# EUROPEAN PATENT SPECIFICATION

(11) **EP 1 094 599 B1**
(45) Date of publication and mention of the grant of the patent: **22.12.2004**
(21) Application number: 99830662.5
(22) Date of filing: 21.10.1999
(51) Int. Cl.: H03F 1/30, H03F 3/30

(54) **A circuit for compensating for the difference between the Vgs voltages of two MOS transistors**
Eine Schaltung zur Kompensation der Differenz der Vgs-Spannungen zweier MOS-Transistoren
Un circuit pour compenser la différence de tension Vgs de deux transistors MOS

(43) Date of publication of application: 25.04.2001
(73) Proprietor: STMicroelectronics S.r.l., 20041 Agrate Brianza (Milano) (IT)
(72) Inventor: Tomasini, Luciano, 20052 Monza (Milano) (IT); Guinea, Jesus, 24041 Brembate (Bergamo) (IT)
(74) Representative: Maggioni, Claudio

(56) References cited:
- EP-A- 0 123 275
- US-A- 4 442 398
- HOGERVORST R ET AL: "COMPACT CMOS CONSTANT-GM RAIL-TO-RAIL INPUT STAGE WITH GM-CONTROL BY AN ELECTRONIC ZENER DIODE" IEEE JOURNAL OF SOLID-STATE CIRCUITS,US,IEEE INC. NEW YORK, vol. 31, no. 7, 1 July 1996 (1996-07-01), pages 1035-1040, XP000632391 ISSN: 0018-9200

## Description

The present invention relates to a circuit for compensating for the difference between the gate-source voltages (Vgs) of two MOS transistors of a device in an integrated circuit as defined in the preamble of Claim 1.

The expression "MOS transistors" defines field-effect transistors which are produced by MOS (metal-oxide semiconductor) technology and are commonly used as basic components of devices in analog and digital integrated circuits. However, the invention also applies, in general, to circuits which use field-effect transistors of different types. This, is however not claimed.

It is known that the characteristics of the components of integrated circuits are liable to vary relative to the design characteristics to a greater or lesser extent because of the variability of the production processes. MOS transistors of different types or dimensions formed in the same circuit may respond differently to process variations. In many applications, particularly in analog circuits, this different behaviour of MOS transistors causes imbalances in the operation of the circuits or undesired deviations from the operation provided for at the design stage.

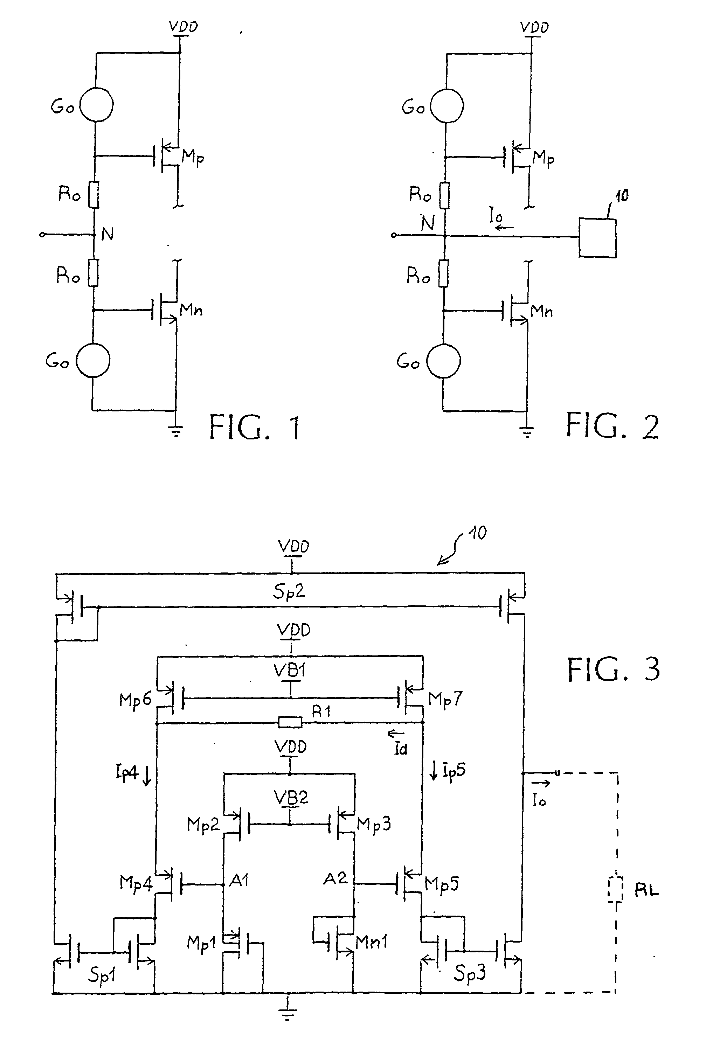

An example of such an application is the input stage of an amplifier. As shown in Figure 1, a stage of this type comprises an n-channel transistor Mn and a p-channel transistor Mp having their source electrodes connected to the terminals of a supply, indicated by the ground symbol and VDD, and their gate electrodes connected to respective biasing circuits comprising, in this example, two identical current generators Go connected, as shown, to an input node N of the stage, each by means of a resistor Ro. The drain electrodes of the two transistors constitute two outputs of the stage and are connected to other components of the amplifier, not shown.

If the stage is required to have a symmetrical response to an input signal applied to the input node N, the generators Go must generate identical currents, the resistors Ro must have the same resistance, and the voltages Vgsn and Vgsp between the gates and sources of the two transistors Mn and Mp must be identical. The first two conditions can be satisfied by sufficient precision but the third cannot generally be satisfied because the two transistors are structurally different from one another and therefore have different characteristic curves. Moreover, the two transistors respond differently to temperature variations in operation.

In this example, two complementary MOS transistors are considered, but similar problems also arise with the use of pairs of MOS transistors of which both are n-channel transistors or both are p-channel transistors, but which have different dimensions or are biased in a manner such that different currents pass through them.

Document US-A-4.442.398 discloses a current generator for generating a current being proportional to the difference in threshold voltages of two differently desiged MOS-FETs.

The object of the present invention is to propose a circuit which compensates for the difference owing to variations in the production process and/or to variations of other parameters, such as temperature, between the gate-source voltages of two MOS transistors of different types.

This object is achieved by the provision of a compensation circuit as defined and characterized in Claim 1.

The invention will be understood better from the following detailed description of an embodiment thereof which is given by way of non-limiting example with reference to the appended drawings, in which:
Figure 1 is a simplified circuit diagram of an input stage of an amplifier,
Figure 2 is a diagram similar to that of Figure 1, modified by the addition of a circuit according to the invention,
Figure 3 is a diagram of a circuit according to the invention,
Figures 4a and 4b show two possible applications of the circuit according to the invention, and
Figure 5 shows a variant of the circuit according to the invention of Figure 3.

Figure 2 shows schematically the amplifier stage of Figure 1, to which a circuit for compensating for the difference between the voltages Vgsn and Vgsp has been added. As will be explained below, the compensation circuit, represented by a block 10, generates a compensation current Io which is injected into the node N.

As can be seen in Figure 3, the compensation circuit 10 comprises two MOS transistors, a p-channel transistor indicated Mp1, and an n-channel transistor indicated Mn1, which are of the same type as the transistors Mp and Mn of Figure 2, that is, which are manufactured in the same device and by the same process stages. In this embodiment, the transistors Mp1 and Mn1 have the same dimensions as the transistors Mp and Mn, respectively but, in general, they could have different dimensions. Each of the two transistors Mp1 and Mn1 has its gate and drain electrodes connected to one another and the transistors Mp1 and Mn1 are connected between the supply terminals, each by means of a constant current generator. In this embodiment, the constant current generators are constituted by two p-channel transistors Mp2 and Mp3 of which the source electrodes are connected together to the terminal VDD, the gate electrodes are connected together to a terminal VB2 of a constant voltage supply, one has its drain electrode connected to the source electrode of the transistor Mp1 at a node A1, and the other has its drain electrode connected to the drain electrode of the transistor Mn1 at a node A2. The transistor Mp1 has its body region connected to its source electrode.

Each of the nodes A1 and A2 is connected to the input of a decoupling stage the outputs of which are connected to one another by means of a resistor R1. In this embodiment, the decoupling stages are constituted by two p-channel MOS transistors Mp4 and Mp5 having their gate electrodes connected to the nodes A1 and A2, respectively, their source electrodes connected to the terminal VDD via respective constant current generators, and their drain electrodes connected to ground via the input branches of respective current mirrors Sp1 and Sp3. The constant-current generators are constituted, respectively, by two p-channel transistors Mp6 and Mp7 having their source electrodes connected together to the terminal VDD, their gate electrodes connected together to a terminal VB1 of a constant-voltage supply, and their drain electrodes connected to the source electrodes of the transistors Mp4 and Mp5, respectively. The output branches of the mirrors Sp1 and Sp3 are in series with the input and output branches, respectively, of a further current mirror Sp2, as shown in Figure 3.

The circuit combination comprising the transistors Mp2 and Mp3 has the function of biasing the transistors Mp1 and Mn1, and the circuit combination comprising the decoupling stages Mp4 and Mp5 and the respective current generators Mp6 and Mp7 has the function of measuring the difference between the gate-source voltages Vgsp and Vgsn of the two transistors Mp1 and Mn1.

The voltages of the nodes A1 and A2 relative to ground, that is, the voltages Vgsp and Vgsn, are reproduced substantially unchanged, by means of the decoupling stages, at the terminals of the resistor R1, so that a current Id proportional to the difference between the voltages Vgsn and Vgsp flows through this resistor.

Upon the assumption that all of the mirrors have a gain equal to 1, a current Io=2Id is supplied to a load RL, shown in broken outline in Figure 3, connected between the connection node between the output branches of the mirrors Sp2 and Sp3 and ground. This can easily be confirmed, bearing in mind that the current passing through the resistor R1 is Id = (Vgsn-Vgsp)/R1 , where R1 is the resistance of the resistor R1, that the currents Ip4 and Ip5 passing through the transistors Mp4 and Mp5, respectively, differ from one another by 2Id, that the currents in the input and output branches of the mirror Sp2 are equal to Ip4, and that the current in the output branch of the mirror Sp3 is equal to Ip5. The injection of the current thus obtained into the node N of the circuit of Figure 2 with the use, as compensation-voltage generators, of two resistors Ro having the same resistance as the resistor R1, adds to or subtracts from the voltages Vgs of the two transistors Mn and Mp a voltage such as to render the drain currents of the two transistors equal to one another. In other words, this compensates for any differences between the Vgs voltages of the two transistors.

Clearly, if the transistors Mp1 and Mn1 are not identical to the transistors Mp and Mn to be compensated but, for example, have different dimensions, it is necessary, in order to achieve the desired compensation, to select resistors Ro having resistances proportional to that of the resistor R1 with a proportionality factor dependent on the ratios between the dimensions of the transistors to be compensated and those of the transistors Mn1 and Mp1 of the compensation circuit 10, also taking account of the currents and the current ratios of the current mirrors.

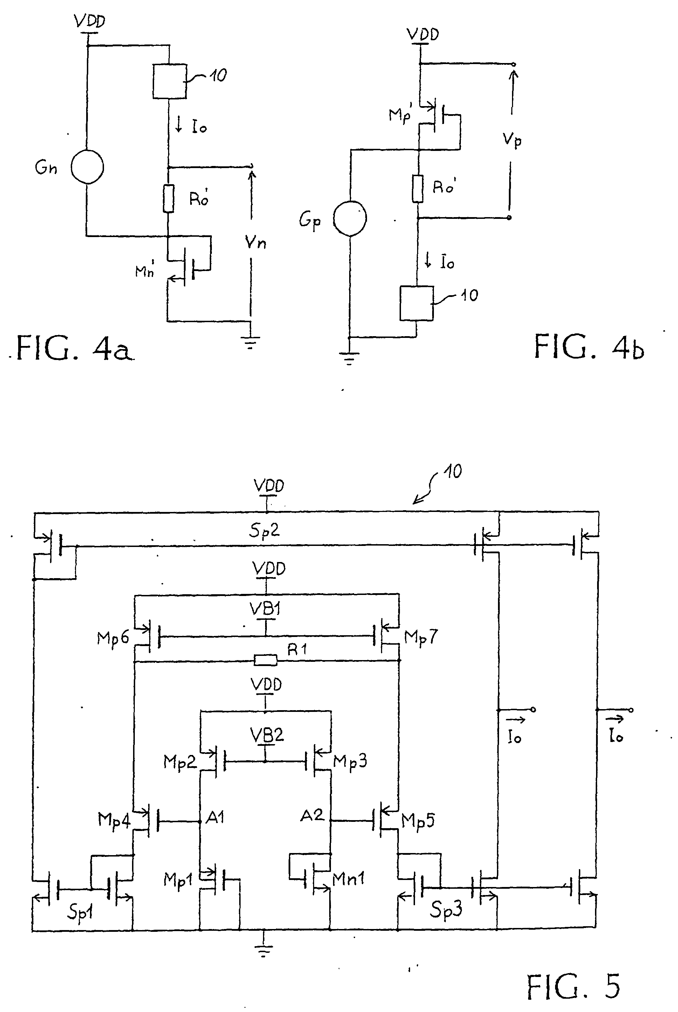

With the same circuit 10 or with a circuit similar thereto, it is also possible to compensate the gate-source voltages of n-channel and p-channel transistors in circuit configurations other than that shown in Figure 2. For example, as shown in Figures 4a and 4b, the transistors Mn' and Mp' may have their gate electrodes connected to their drain electrodes and may be biased by respective generators Gn and Gp connected between their drain electrodes and respective supply terminals Vdd and ground. The compensation current Io is injected into the drain electrode of the respective transistor Mn', Mp' via a resistor Ro'. If the transistors Mn' and Mp' are identical to the transistors Mn1 and Mp1, respectively, compensation is achieved with the use of resistors Ro' having the same resistance as the resistor R1; otherwise, the resistance value is selected so as to be proportional to that of the resistor R1 with a proportionality factor which depends on the ratio between the dimensions of the transistors Mn' and Mp' to be compensated and those of the transistors Mn1 and Mp1 of the circuit 10. The compensated voltages Vn and Vp are given by the sum of the gate-source voltages Vgsn and Vgsp of the transistors Mn' and Mp', respectively, and by the voltage drop in the resistors Ro'.

It is intended that, if the transistors to be compensated belong to separate circuits, as shown in Figures 4a, and 4b, the mirrors Sp2 and Sp3 should have two separate output branches, as shown in Figure 5. Moreover, if there are more than two transistors to be compensated it may clearly be necessary to modify the mirrors Sp2 and Sp3 in a manner such that they have as many output branches as there are transistors to be compensated independently of one another.

Although only one embodiment of the invention has been described and illustrated, clearly many variations are possible within the scope of the same inventive concept as defined by the appended claims. For example, instead of a resistor, another component such as a MOS transistor biased to the linear zone may be used as the compensation current generator.

## Claims

1. A circuit for compensating for the difference between the gate-source voltages of a first MOS transistor (Mp) and a second MOS transistor (Mn) of an integrated circuit device, **characterized in that** it comprises:
- a third MOS transistor (Mp1) and a fourth MOS transistor (Mn1) which are of the same type as the first transistor (Mp) and the second transistor (Mn), respectively, and are formed in the same device,
- means (VDD, Mp2, Mp3) for biasing the third transistor (Mp1) and the fourth transistor (Mn1),
- means (Mp4-Mp7) for measuring the difference between the gate-source voltages of the third and fourth transistors (Mp1, Mn1),
- means (R1) for generating a compensation current (Io) which is a predetermined function of the difference measured, and
- means (S1-Sp3, Ro) for modifying the biasing of the first MOS transistor (Mp) and the second MOS transistor (Mn) with the use of the compensation current (Io).

2. A circuit according to Claim 1, in which the means for biasing the third transistor (Mp1) and the fourth transistor (Mn1) comprise a first current generator (Mp2) and a second current generator (Mp3) connected in series with the third MOS transistor (Mp1) and with the fourth MOS transistor (Mn1), respectively, and the difference measuring means comprise a first decoupling stage (Mp4) and a second decoupling stage (Mp5) having their respective inputs (A1, A2) connected between the source and drain electrodes of the third MOS transistor (Mp1) and of the fourth MOS transistor (Mn1), respectively, and their respective outputs connected to the means (R1) for generating a compensation current (Io).

3. A circuit according to Claim 2, in which the means for modifying the biasing comprise a first current mirror (Sp1), a second current mirror (Sp2), and a third current mirror (Sp3) and means (Ro, Ro') for generating a compensation voltage, the first mirror (Sp1) having an input branch connected to one (Mp4) of the decoupling stages and an output branch in series with an input branch of the second mirror (Sp2), the third mirror (Sp3) having an input branch connected to the other (Mp5) of the decoupling stages and an output branch in series with an output branch of the second mirror (Sp2), the means (Ro, Ro') for generating a compensation voltage being connected between the output branch of the third mirror (Sp3) and a predetermined electrode of each of the first and second MOS transistors (Mp, Mn).

4. A circuit according to Claim 3, in which the first and second MOS transistors are a p-channel MOS transistor (Mp) and an n-channel MOS transistor (Mn) of the input stage of an amplifier, in which the third and fourth MOS transistors are a p-channel MOS transistor (Mp1) and an n-channel MOS transistor (Mn1), in which the means for generating a compensation voltage comprise two resistors (Ro), and in which the predetermined electrode is the gate electrode.

5. A circuit according to Claim 3, in which the first and second MOS transistors are a p-channel MOS transistor (Mp') and an n-channel MOS transistor (Mn') each having its gate and drain electrodes connected to one another, in which the means for generating a compensation voltage comprise two resistors (Ro'), and in which the predetermined electrode is the drain electrode.

## Patentansprüche

1. Eine Schaltung zum Kompensieren der Differenz zwischen den Gate-Source-Spannungen eines ersten MOS-Transistors (Mp) und eines zweiten MOS-Transistors (Mn) einer integrierten Schaltungsvorrichtung, **dadurch gekennzeichnet, dass** dieselbe folgende Merkmale aufweist:
- einen dritten MOS-Transistor (Mp1) und einen vierten MOS-Transistor (Mn1), die von dem gleichen Typ wie der erste Transistor (Mp) bzw. der zweite Transistor (Mn) sind und in der gleichen Vorrichtung gebildet sind,
- eine Einrichtung (VDD, Mp2, Mp3) zum Vorspannen des dritten Transistors (Mp1) und des vierten Transistors (Mn1),
- eine Einrichtung (Mp4 - Mp7) zum Messen der Differenz zwischen den Gate-Source-Spannungen des dritten und des vierten Transistors (Mp1, Mn1),
- eine Einrichtung (R1) zum Erzeugen eines Kompensationsstroms (Io), der eine vorbestimmte Funktion der gemessenen Differenz ist, und
- eine Einrichtung (S1 - Sp3, Ro) zum Modifizieren des Vorspannens des ersten MOS-Transistors (Mp) und des zweiten MOS-Transistors (Mn) mit der Verwendung des Kompensationsstroms (Io).

2. Eine Schaltung gemäß Anspruch 1, bei der die Einrichtung zum Vorspannen des dritten Transistors (Mp1) und des vierten Transistors (Mn1) einen ersten Stromgenerator (Mp2) und einen zweiten Stromgenerator (Mp3) aufweist, die mit dem dritten MOS-Transistor (Mp1) bzw. mit dem vierten MOS-Transistor (Mn1) in Reihe geschaltet sind, und die Differenzmesseinrichtung eine erste Entkopplungsstufe (Mp4) und eine zweite Entkopplungsstufe (Mp5) aufweist, deren jeweilige Eingänge (A1, A2) zwischen die Source- und die Drain-Elektrode des dritten MOS-Transistors (Mp1) bzw. des vierten MOS-Transistors (Mn1) geschaltet sind und deren jeweilige Ausgänge mit der Einrichtung (R1) zum Erzeugen eines Kompensationsstroms (Io) verbunden sind.

3. Eine Schaltung gemäß Anspruch 2, bei der die Einrichtung zum Modifizieren des Vorspannens einen ersten Stromspiegel (Sp1), einen zweiten Stromspiegel (Sp2) und einen dritten Stromspiegel (Sp3) und eine Einrichtung (Ro, Ro') zum Erzeugen einer Kompensationsspannung aufweist, wobei der erste Spiegel (Sp1) einen Eingangszweig, der mit einer (Mp4) der Entkopplungsstufen verbunden ist, und einen Ausgangszweig in Reihe mit einem Eingangszweig des zweiten Spiegels (Sp2) aufweist, wobei der dritte Spiegel (Sp3) einen Eingangszweig, der mit der anderen (Mp5) der Kopplungsstufen verbunden ist, und einen Ausgangszweig in Reihe mit einem Ausgangszweig des zweiten Spiegels (Sp2) aufweist, wobei die Einrichtung (Ro, Ro') zum Erzeugen einer Kompensationsspannung zwischen den Ausgangszweig des dritten Spiegels (Sp3) und eine vorbestimmte Elektrode von jedem des ersten und des zweiten MOS-Transistors (Mp, Mn) geschaltet ist.

4. Eine Schaltung gemäß Anspruch 3, bei der der erste und der zweite MOS-Transistor ein p-Kanal-MOS-Transistor (Mp) und ein n-Kanal-MOS-Transistor (Mn) der Eingangsstufe eines Verstärkers sind, bei der der dritte und der vierte MOS-Transistor ein p-Kanal-MOS-Transistor (Mp1) und ein n-Kanal-MOS-Transistor (Mn1) sind, bei der die Einrichtung zum Erzeugen einer Kompensationsspannung zwei Widerstände (Ro) aufweist und bei der die vorbestimmte Elektrode die Gate-Elektrode ist.

5. Eine Schaltung gemäß Anspruch 3, bei der der erste und der zweite MOS-Transistor ein p-Kanal-MOS-Transistor (Mp') und ein n-Kanal-MOS-Transistor (Mn') sind, deren Gate- und Drain-Elektroden jeweils miteinander verbunden sind, bei der die Einrichtung zum Erzeugen einer Kompensationsspannung zwei Widerstände (Ro') aufweist und bei der die vorbestimmte Elektrode die Drain-Elektrode ist.

## Revendications

1. Circuit pour compenser la différence entre les tensions grille-source d'un premier transistor MOS (Mp) et d'un deuxième transistor MOS (Mn) d'un dispositif à circuit intégré, **caractérisé en ce qu'**il comprend :
- un troisième transistor MOS (Mp1) et un quatrième transistor MOS (Mn1) qui sont du même type que le premier transistor MOS (Mp) et le deuxième transistor MOS (Mn), respectivement, et sont formés dans le même dispositif,
- des moyens (VDD, Mp2, Mp3) pour polariser le troisième transistor (Mp1) et le quatrième transistor (Mn1),
- des moyens (Mp4-Mp7) pour mesurer la différence entre les tensions grille-source des troisième et quatrième transistors (Mp1, Mn1),
- des moyens (R1) pour générer un courant de compensation (Io) qui est une fonction prédéterminée de la différence mesurée, et
- des moyens (S1-Sp3, Ro) pour modifier la polarisation du premier transistor MOS (Mp) et du deuxième transistor MOS (Mn) avec l'utilisation du courant de compensation (Io).

2. Circuit selon la revendication 1, dans lequel les moyens pour polariser le troisième transistor (Mp1) et le quatrième transistor (Mn1) comprennent un premier générateur de courant (Mp2) et un deuxième générateur de courant (Mp3) connectés en série avec le troisième transistor (Mp1) et avec le quatrième transistor (Mn1), respectivement, et les moyens de mesure de différence comprennent un premier étage de découplage (Mp4) et un deuxième étage de découplage (Mp5) ayant leurs entrées respectives (A1, A2) connectées entre les électrodes de source et de drain du troisième transistor (Mp1) et du quatrième transistor (Mn1), respectivement, et leurs sorties respectives connectées aux moyens (R1) pour générer un courant de compensation (Io).

3. Circuit selon la revendication 2, dans lequel les moyens pour modifier la polarisation comprennent un premier miroir de courant (Sp1), un deuxième miroir de courant (Sp2) et un troisième miroir de courant (Sp3) et des moyens (Ro, Ro') pour générer une tension de compensation, le premier miroir (Sp1) ayant une branche d'entrée connectée à un (Mp4) des étages de découplage et une branche de sortie en série avec une branche d'entrée du deuxième miroir (Sp2), le troisième miroir (Sp3) ayant une branche d'entrée connectée à l'autre (Mp5) des étages de découplage et une branche de sortie en série avec une branche de sortie du deuxième miroir (Sp2), les moyens (Ro, Ro') pour générer une tension de compensation étant connectés entre la branche de sortie du troisième miroir (Sp3) et une électrode prédéterminée de chacun des premier et deuxième transistors MOS (Mp, Mn).

4. Circuit selon la revendication 3, dans lequel les premier et deuxième transistors MOS sont un transistor MOS à canal P (Mp) et un transistor MOS à canal N (Mn) de l'étage d'entrée d'un amplificateur, dans lequel les troisième et quatrième transistors MOS sont un transistor MOS à canal P (Mp1) et un transistor MOS à canal N (Mn1), dans lequel les moyens pour générer une tension de compensation comprennent deux résistances (Ro) et dans lequel l'électrode prédéterminée est l'électrode de grille.

5. Circuit selon la revendication 3, dans lequel les premier et deuxième transistors MOS sont un transistor MOS à canal P (Mp') et un transistor MOS à canal N (Mn') ayant chacun ses électrodes de grille et de drain connectées l'une à l'autre, dans lequel les moyens pour générer une tension de compensation comprennent deux résistances (Ro') et dans lequel l'électrode prédéterminée est l'électrode de drain.
